# EUROPEAN PATENT SPECIFICATION

(11) **EP 0 822 734 B1**
(45) Date of publication and mention of the grant of the patent: **08.01.2003**
(21) Application number: 97305687.2
(22) Date of filing: 29.07.1997
(51) Int. Cl.: H05B 6/80, H05K 9/00

(54) **PCB grounding**
Erdung einer Leiterplatte
Mise à la terre d'un circuit imprimé

(30) Priority: 29.07.1996 KR 9622582
(43) Date of publication of application: 04.02.1998
(73) Proprietor: SAMSUNG ELECTRONICS CO., LTD., Suwon-City, Kyungki-do (KR)
(72) Inventor: Kim, Geun-Soo, Seoul (KR)
(74) Representative: Read, Matthew Charles

(56) References cited:
- EP-A- 0 073 250
- EP-A- 0 332 909
- DE-U- 8 213 627
- DE-U- 8 711 015
- PATENT ABSTRACTS OF JAPAN vol. 097, no. 001, 31 January 1997 & JP 08 233286 A (TOSHIBA CORP;TOSHIBA AVE CORP), 10 September 1996,

## Description

The present invention relates to an apparatus comprising a body or chassis, a non-conductive control panel and a circuit assembly screwed to the control panel.

A microwave oven is an example of an apparatus to which the present invention may be applied. Generally, a microwave oven is designed to generate microwaves to heat and cook food. The microwave oven is provided with a control panel equipped with a control key.

A printed circuit board (hereinafter referred to as PCB) for electrically controlling the microwave oven according to a signal input by means of the control key is fastened and fixed to the rear of the control panel.

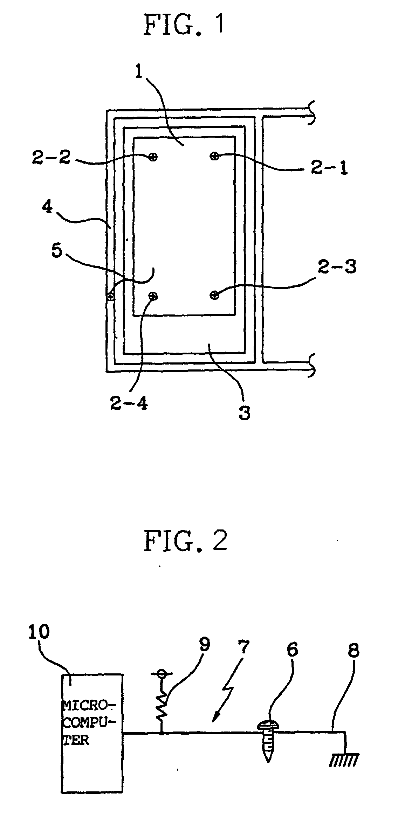

In a conventional microwave oven, as illustrated in Figure 1, the PCB 1 is secured to a plastic control panel 3 by way of a plurality of screws 2-1,2-2,2-3, 2-4. A ground pattern formed on the PCB 1 and the body 4 of the microwave oven, made of steel, are connected by a ground wire 5 to thereby ground the PCB 1 to the body 4 of the microwave oven.

However, there is a problem in a ground structure of a PCB according to the prior art thus constructed, in that a separate ground wire 5 must be pulled out of the PCB 1 to be connected to the body 4, which leads to inconveniences in assembly of the microwave oven.

Furthermore, there is another problem in that an operator often forgets to connect the ground wire 5 to the body 4 of the microwave oven to thereby cause a safety problem because the PCB 1 is not grounded to the body 4.

A microwave oven, disclosed in JP-A-08-233286, has a construction where a PCB is screwed to an inner side of a panel provided with a control key, so that a screw fastening member cannot be forgotten in fastening. In the microwave oven thus constructed, as illustrated in Figure 2, the PCB is formed with a screw hole through which the PCB is fastened by means of a fastening screw to an inner side of the panel provided with the control key. The PCB is formed with a screw hole which in turn renders the same unconductive, but the PCB is rendered conductive by way of the screw being plugged into the screw hole. Accordingly, a microcomputer 10 connected to the PCB can determine whether or not a screw is inserted thereinto according to the potential of the PCB. The conventional microwave oven thus constructed can only discriminate whether or not a screw for fixing the PCB to a control panel is accurately fastened.

The present invention provides a solution to the afore-mentioned problem in the case of microwave ovens and more generally.

An apparatus according to the present invention is characterised in that the body or chassis is provided with a member extending across a part of the circuit assembly, and the circuit assembly is screwed to the control panel by a grounding screw passing through said member and the circuit assembly, to thereby ground the circuit assembly to the body or chassis via said member, and into the control panel. The member may comprise a bar.

The present invention may be advantageously applied to a microwave oven, in which case it is prefered that the circuit assembly comprises a printed circuit board having a jumper wire near a screw hole and connected to a ground pattern on the printed circuit board, the grounding screw extends through said screw hole, and the member contacts the jumper wire.

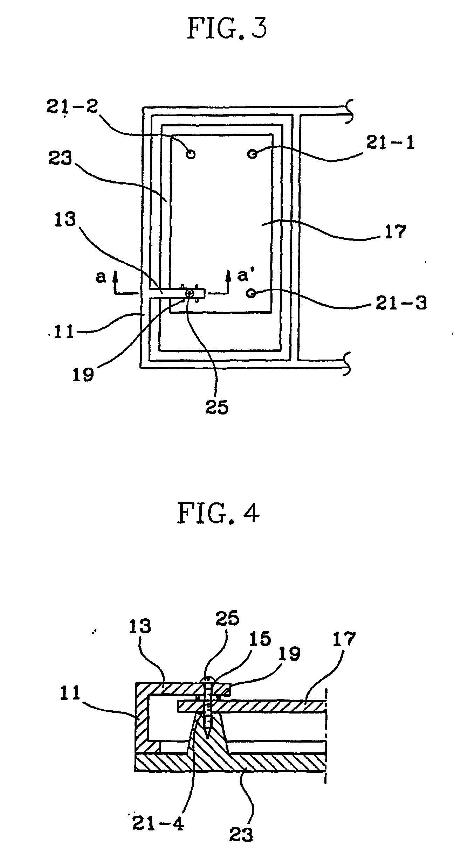

An embodiment of the present invention will now be described, by way of example, with reference to Figures 3 and 4 of the accompanying drawings, in which:
Figure 1 is a schematic diagram illustrating one prior art example of a grounding arrangement for a control panel mounted PCB;
Figure 2 is a circuit diagram illustrating a screw detecting circuit of a prior art microwave oven;
Figure 3 is schematic diagram illustrating a grounding arrangement according to the present invention; and
Figure 4 is a sectional view taken along line a-a' in Figure 3.

Referring to Figures 3 and 4, a bar 13 extends from the steel body 11 of a microwave oven and has a screw hole 15 formed at its free end. A printed circuit board 17 (hereinafter referred to as PCB) is provided with a plurality of screw holes 21-1, 21-2, 21-3, 21-4 and a jumper wire 19 connected to a ground pattern is secured around one of the plurality of screw holes 21-1, 21-2, 21-3, 21-4. A screw 25 is screwed into a control panel 23 through the screw hole 15 formed at the tip end of the bar 13 and through a screw hole 21-4 formed at the PCB 17. The bar 25 contacts the jumper wire 19 so that the PCB 17 is automatically connected and grounded to the body 11 of the microwave oven when the PCB 17 is fastened to the control panel 23.

Now, operational of the microwave oven thus constructed will be described in detail.

The screw 25 is passed through the screw hole 15 and through the screw hole 21-1, and screwed into the plastic control panel 23. When the PCB 17 is fixed to the control panel 23, the jumper wire 19, which is connected to the ground pattern of the PCB 17, contacts the bar 13. Thus, the PCB 17 is grounded to the body 11 of the microwave oven via the jumper wire 19 and the bar 13.

As apparent from the foregoing, there is an advantage to an apparatus according to the present invention, in that a PCB is automatically grounded to the body or chassis when the PCB is fastened to a control panel.

## Claims

1. An apparatus comprising a body or chassis (11), a non-conductive control panel (23) and a circuit assembly (17) screwed to the control panel (23), **characterised in that** the body or chassis (11) is provided with a member (13) extending across a part of the circuit assembly (17), and the circuit assembly (17) is screwed to the control panel (23) by a grounding screw (25) passing through said member (13) and the circuit assembly, to thereby ground the circuit assembly (17) to the body or chassis (11) via said member (13), and into the control panel (23).

2. An apparatus according to claim 1, wherein said member comprises a bar (13).

3. A microwave oven according to claim 1 or 2.

4. A microwave oven according to claim 3, wherein the circuit assembly (17) comprises a printed circuit board having a jumper wire (19) near a screw hole (21-4) and connected to a ground pattern on the printed circuit board, the grounding screw (25) extending through said screw hole (21-4) and the member (13) contacting the jumper wire (19).

## Patentansprüche

1. Vorrichtung, umfassend einen Körper oder ein Chassis (11), eine nichtleitende Schalttafel (23) und eine mit der Schalttafel (23) verschraubte Schaltungsbaugruppe (17), **dadurch gekennzeichnet, dass** der Körper oder das Chassis (11) mit einem Element (13) versehen ist, das über einen Teil der Schaltungsbaugruppe (17) verläuft, und die Schaltungsbaugruppe (17) mit der Schalttafel (23) mit einer Erdungsschraube (25) verschraubt ist, die durch das genannte Element (13) und die Schaltungsbaugruppe, um dadurch die Schaltungsbaugruppe (17) über das genannte Element (13) auf den Körper oder Chassis (11) zu erden, und in die Schalttafel (23) verläuft.

2. Vorrichtung nach Anspruch 1, bei der das genannte Element einen Stab (13) umfasst.

3. Mikrowellenherd nach Anspruch 1 oder 2.

4. Mikrowellenherd nach Anspruch 3, bei dem die Schaltungsbaugruppe (17) eine Leiterplatte mit einem Schaltdraht (19) in der Nähe eines Schraublochs (21-4) umfasst und mit einer Erdungsstruktur auf der Leiterplatte verbunden ist, wobei die Erdungsschraube (25) durch das genannte Schraubloch (21-4) verläuft und das Element (13) mit dem Schaltdraht (19) Kontakt hat.

## Revendications

1. Un appareil comprenant un corps ou châssis (11), un tableau de commande non conducteur (23) et un ensemble de circuits (17) vissé sur le tableau de commande (23), **caractérisé en ce que** le corps ou châssis (11) est pourvu d'un élément (13) qui s'étend en travers d'une partie de l'ensemble de circuits (17), et l'ensemble de circuits (17) est vissé sur le tableau de commande (23) par une vis de mise à la masse (25) qui passe à travers ledit élément (13) et l'ensemble de circuits, de sorte à mettre à la masse l'ensemble de circuits (17) sur le corps ou châssis (11) par l'intermédiaire dudit élément (13), et dans le tableau de commande (23).

2. Un appareil selon la revendication 1, dans lequel ledit élément comprend une barre (13).

3. Un four à micro-ondes selon la revendication 1 ou 2.

4. Un four à micro-ondes selon la revendication 3, dans lequel l'ensemble de circuits (17) comprend une carte imprimée ayant un cavalier (19) près d'un trou de vissage (21-4) et connecté à un motif de mise à la masse sur la carte imprimée, la vis de mise à la masse (25) s'étendant à travers ledit trou de vissage (21-4) et l'élément (13) contactant le cavalier (19).
